# EUROPEAN PATENT APPLICATION

(11) **EP 4 654 771 A1**
(43) Date of publication of application: **26.11.2025**
(21) Application number: 23941052.5
(22) Date of filing: 15.06.2023
(51) Int. Cl.: H10B 12/00

(54) **SEMICONDUCTOR DEVICE AND MANUFACTURING METHOD THEREFOR, AND STORAGE SYSTEM**

(71) Applicant: Yangtze Memory Technologies Co., Ltd., Wuhan, Hubei 430205 (CN)
(72) Inventor: YANG, Zijin, Wuhan, Hubei 430205 (CN); WANG, Ya, Wuhan, Hubei 430205 (CN); LIU, Fandong, Wuhan, Hubei 430205 (CN); HUA, Wenyu, Wuhan, Hubei 430205 (CN); TANG, Zhaoyun, Wuhan, Hubei 430205 (CN)
(74) Representative: Gramm, Lins & Partner Patent- und Rechtsanwälte PartGmbB
(86) International application number: PCT/CN2023/100386
(87) International publication number: WO 2024/254816

(57) **Abstract**

The present application discloses a semiconductor device and a fabrication method thereof, and a memory system. The device includes a plurality of semiconductor pillars extending in a third direction, and a plurality of gate structures and shielding structures extending along a first direction. The gate structures and the shielding structures are in a staggered distribution along a second direction, and the semiconductor pillars are located between the shielding structures and the gate structures that are adjacent. Sizes of the gate structures along the first direction are smaller than sizes of the shielding structures along the first direction, and orthographic projections of the gate structures are within ranges of orthographic projections of the shielding structures along the second direction.

## Description

### TECHNICAL FIELD

The present application relates to the technical field of semiconductors, and particularly to a semiconductor device and a fabrication method thereof, and a memory system.

### BACKGROUND

As feature sizes of memory cells approach the lower limit of processes, planar processes and fabrication technologies become challenging and costly, which leads to a storage density of a memory of a 2D structure approaching the upper limit.

In order to overcome the limitations brought about by the memory of the 2D structure, the industry has developed a memory with a three-dimensional structure to increase the storage density.

However, with increasing requirements for an integration level of the memory, currently how to properly arrange various gate lines to reduce mutual interference between them is still a problem to be overcome.

### SUMMARY

The present application provides a semiconductor device and a fabrication method thereof, and a memory system, which can increase yield and reliability of the memory.
a first region that comprises a semiconductor pillar array, wherein the semiconductor pillar array comprises a plurality of semiconductor pillars that are arranged in an array along a first direction and a second direction and extend in a third direction, and the first direction, the second direction and the third direction intersect each other;
a gate structure extending along the first direction and disposed on a sidewall of each of the semiconductor pillars; and
a shielding structure extending along the first direction and disposed between adjacent ones of the semiconductor pillars, wherein the gate structures on the sidewalls of adjacent ones of the semiconductor pillars are located on different sides, and the gate structure and the shielding structure are located on different sides of the same semiconductor pillar,
wherein a size of the gate structure along the first direction is smaller than a size of the shielding structure along the first direction, and an orthographic projection of the gate structure is within a range of an orthographic projection of the shielding structure along the second direction.

In a second aspect, the present application provides a fabrication method of a semiconductor device, which comprises:
providing a substrate;
forming first grooves that extend along a second direction and are arranged as being spaced apart along a first direction in the substrate, wherein the first direction intersects the second direction;
depositing a dielectric material in the first grooves;
forming second grooves and third grooves extending along the first direction in the substrate, wherein the second grooves and the third grooves are spaced apart in a staggered arrangement along the second direction, sizes of the second grooves along the first direction are smaller than sizes of the third grooves along the first direction, and orthographic projections of the second grooves are within ranges of orthographic projections of the third grooves along the second direction;
forming gate line structures in the second grooves; and
forming shielding structures in the third grooves.

In a third aspect, the present application further provides a memory system, comprising: a memory controller and a three-dimensional memory, wherein the memory controller is coupled to the three-dimensional memory and configured to control the three-dimensional memory to store data, and the three-dimensional memory comprises one or more semiconductor devices of the first aspect.

The present application has the advantageous effects that: the extending sizes of the shielding structures in the first direction are greater than the extending directions of the gate structures in the first direction, such that the shielding structures can be led out through ends extending beyond the gate structures along the first direction, which facilitates leading-out, and at the same time, reduces interference between different signals and improves stability of the semiconductor device.

### BRIEF DESCRIPTION OF THE DRAWINGS

The drawings to be used in description of examples will be briefly introduced below in order to illustrate the technical solutions in the examples of the present application more clearly. Apparently, the drawings described below are only some examples of the present application. Those skilled in the art may obtain other drawings according to these drawings without creative work.
FIG. 1 is a cross-sectional view of a semiconductor device provided by an example of the present application;
FIG. 2 is a top view of a substrate of a semiconductor device provided by an example of the present application;
FIG. 3 is a top view of forming first grooves provided by an example of the present application;
FIG. 4 is a cross-sectional view of forming first grooves along a cutting line EE' in FIG. 3 provided by an example of the present application;
FIG. 5 is a top view of depositing a dielectric material in first grooves provided by an example of the present application;
FIG. 6 is a cross-sectional view of depositing a dielectric material in first grooves provided by an example of the present application;
FIG. 7 is a top view of forming second grooves and third grooves provided by an example of the present application;
FIG. 8 is a cross-sectional view of forming second grooves and third grooves along a cutting line AA' in FIG. 7 provided by an example of the present application;
FIG. 9 is a top view of forming shielding structures and gate structures provided by an example of the present application;
FIG. 10 is a cross-sectional view of forming shielding structures and gate structures provided by an example of the present application;
FIG. 11 is a cross-sectional structure view of forming shielding structures and gate structures provided by an example of the present application;
FIG. 12 is a top view of a semiconductor device provided by an example of the present application;
FIG. 13 is a cross-sectional view of a semiconductor device along a cutting line BB' in FIG. 12 provided by an example of the present application;
FIG. 14 is another top view of a semiconductor device provided by an example of the present application;
FIGs. 15 and 16 are cross-sectional views of a semiconductor device along a cutting line CC' in FIG. 14 provided by an example of the present application;
FIGs. 17 and 18 are cross-sectional views of a semiconductor device along a cutting line DD' in FIG. 14 provided by an example of the present application;
FIG. 19 is another top view of a semiconductor device provided by an example of the present application;
FIGs. 20 and 21 are cross-sectional views of a semiconductor device along a cutting line DD' in FIG. 19 provided by an example of the present application;
FIG. 22 is a structure view of a semiconductor device provided by an example of the present application;
FIG. 23 is a flow diagram of a fabrication method of a semiconductor device provided by an example of the present application; and
FIG. 24 is a schematic structure diagram of a memory system provided by an example of the present application.

### DETAILED DESCRIPTION

The technical solutions in examples of the present application will be described below clearly and completely in conjunction with the drawings in the examples of the present application. Apparently, the examples described are only part of, but not all of, the examples of the present application. All other examples obtained by those skilled in the art based on the examples in the present application without creative work shall fall in the scope of protection of the present application. Furthermore, it should be understood that, the detailed description described herein is only to illustrate and explain the present application, instead of restricting the present application. In the present application, in the case where the contrary is not stated, the directional words used, such as "upper" and "lower" typically refer to upper and lower of a device in an actual use or working state, specifically in the direction of the page in the drawings, and "inner" and "outer" refer to the outline of the apparatus.

With the increasing density of semiconductor memory devices, memory cells present a characteristic of shrinking physical volume, word lines in the memory cells are physically closer, and capacitive coupling between adjacent ones of the word lines increases. When the number of accesses to some row in the memory cells exceeds a threshold, it may lead to data abnormity on neighboring rows, which is typically called the Row Hammer effect. The Row Hammer effect refers to the phenomenon that, when some word line is repeatedly accessed within a certain period of time, another adjacent word line sharing a bit line with that word line is turned on, resulting in loss of information in the capacitor.

A dynamic random access memory (DRAM) is a common semiconductor memory device in computers, and consists of many duplicate memory cells, and different memory cells need to undergo selection operation via word lines and bit lines. The DRAM comprises a memory cell region consisting of multiple memory cells, and a peripheral area consisting of a control circuit. Each memory cell comprises a transistor electrically connected to a capacitor, and the transistor controls storage or release of charge in the capacitor to achieve the purpose of storing data. The control circuit may locate each memory cell to control access of its data by using the word lines (WLs) and the bit lines (BLs) that are across the memory cell region and are electrically connected with each memory cell.

With the refinement of manufacturing processes of semiconductor devices such as the dynamic random access memory (DRAM), etc., the Row Hammer effect often occurs while the device size shrinks. Since a large number of word lines exist in the DRAM and these word lines are in adjacent arrangement, when some word line undergoes the Row Hammer effect, data errors may occur in the memory cells on the word line adjacent to that word line.

In some related technologies, the DRAM performs a refreshing operation periodically to retain charges stored in the memory cells to avoid data loss. Harms caused by the Row Hammer effect may be relieved to some extent by increasing the periodic refreshing frequency, which can ensure that each row is refreshed before the Row Hammer effect may cause enough damage to the cell charges to cause errors. However, the above method will spend unnecessary time or power to refresh other rows not affected by the Row Hammer effect, such that the memory device that receives a refreshing command cannot limit its refreshing range to the rows damaged by the Row Hammer effect. Thus, system power needs to be increased and system performance may be lowered because additional refreshing periods will reduce the bandwidth of the memory system.

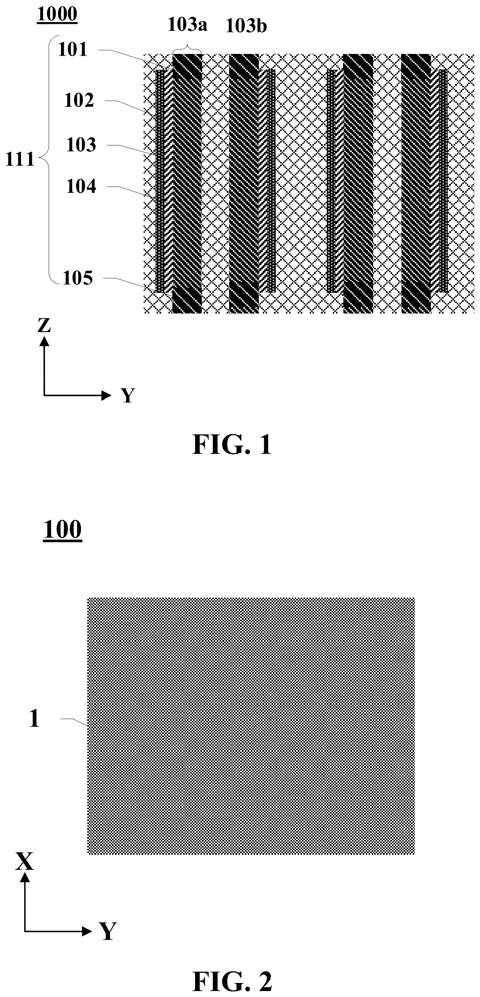

FIG. 1 shows a partial cross-sectional view of a semiconductor device 1000 having a transistor array (not shown in the figure). The transistor array comprises pillar-shaped channels 103. The transistor array comprises transistors arranged in an array. All the pillar-shaped channels 103 of the transistor array are distributed in an array along a first direction and a second direction. An extending direction of the pillar-shaped channels 103 is perpendicular to a plane constituted by the first direction and the second direction. A gate oxidization layer 104 and a gate structure 102 are provided on a sidewall of each pillar-shaped channel 103 of the transistor array, wherein the gate structure 102 extends along the first direction. A source region 101 and a drain region 105 are provided respectively at two ends of each pillar-shaped channel 103 of the transistor array in the extending direction. In some examples, positions of the source region 101 and the drain region 105 may be interchanged. Here, an X direction is the first direction, and a Y direction is the second direction. However, as shown in FIG. 1, the pillar-shaped channel 103 coupled to an unselected word line adjacent to a selected word line is easily affected, mainly because activities on the adjacent word line may result in charge variation in cells of the unselected word line, which brings risks to the information stored therein. For example, when the selected word line connected with the pillar-shaped channel 103a is active, it will interfere with the adjacent pillar-shaped channel 103b and affect the performance of the device. Thus, a further improvement is required. In some other related technologies, an air gap structure is formed between adjacent ones of the pillar-shaped channels 103, which, however, requires higher process consistency. Alternatively, in some other related technologies, a metal layer (not shown in the figure) for electrically isolating adjacent ones of the pillar-shaped channels 103 is formed therebetween. However, since it is needed to achieve leading-out of structures such as the bit lines, the word lines and the metal layer, etc. in subsequent processes, circuit routing in the memory array area of the memory is complex and the manufacturing process is difficult, resulting in increased costs.

In order to improve the above problem, referring to FIGs. 2 to 24, examples of the present application provide a semiconductor device 100 and a fabrication method thereof, and a memory system. Extending sizes of shielding structures 30 of the present application in a first direction are greater than extending sizes of gate structures 10 in the first direction, such that the shielding structures 30 may be led out through ends extending beyond the gate structures 10 along the first direction. As such, the shielding structures 30 are led out separately, which not only facilitates leading-out but also eliminates the Row Hammer effect. The semiconductor device 100 of the present application has low fabrication costs and improves the problem of yield loss caused by the Row Hammer effect, which reduces the requirements on process consistency, simplifies the manufacturing process, and reduces manufacturing costs.

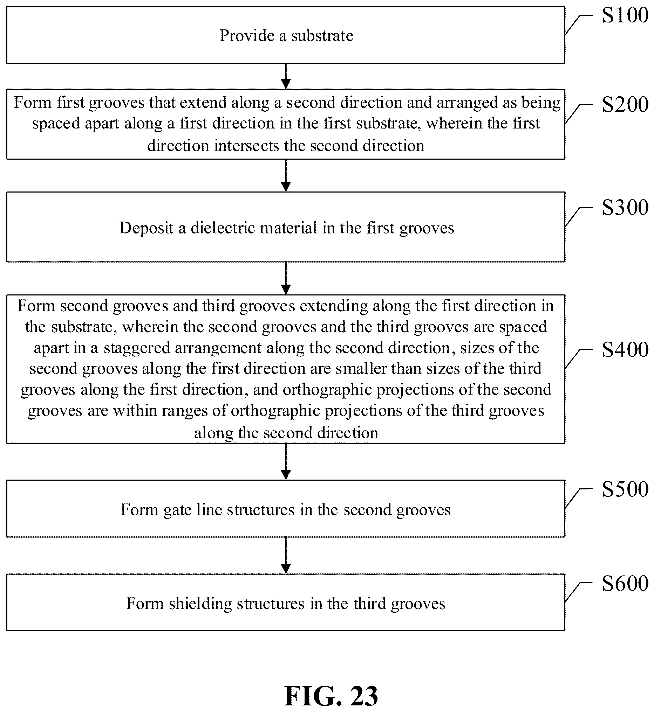

Referring to FIG. 23, which is a flow diagram of a fabrication method of a semiconductor device 100 provided by an example of the present application, the specific process flow comprises the following operations with reference to the structure views in FIGs. 2 to 22:

Operation S100, providing a substrate 1, as shown in FIG. 2.

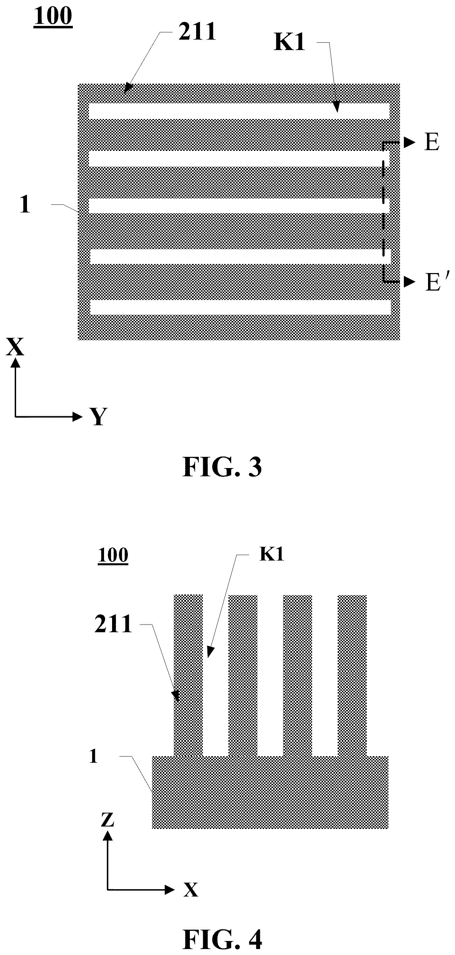

Operation S200, forming first grooves K1 extending along a second direction Y and arranged as being spaced apart along a first direction X in the substrate 1, wherein the first direction X intersects the second direction Y, as shown in FIG. 3.

In some examples, there is an included angle between the first direction X and the second direction Y, and there is an included angle between a third direction Z and a plane where the first direction X and the second direction Y are located, and a range of the included angles is less than or equal to 90 degrees. For example, the first direction X is set as an X direction, the second direction Y is set as a Y direction, and the third direction Z is set as a Z direction in some examples of the present application.

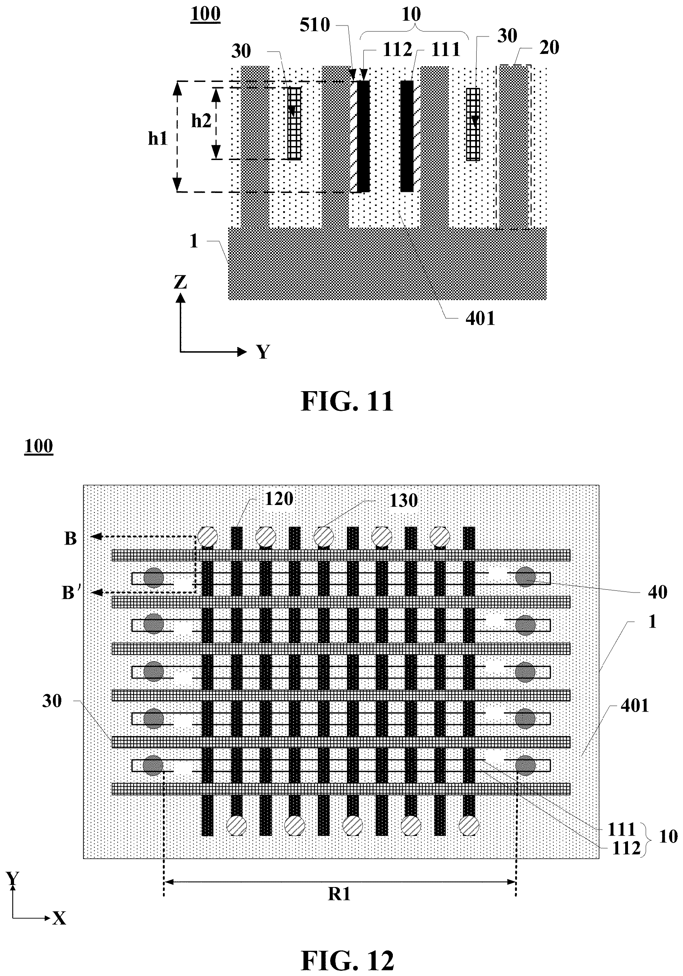

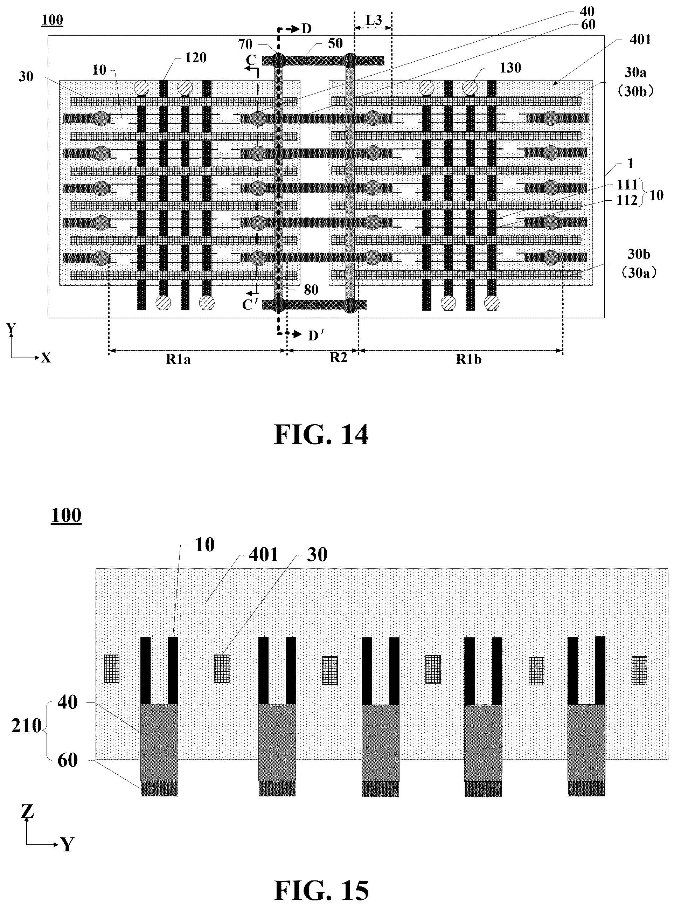

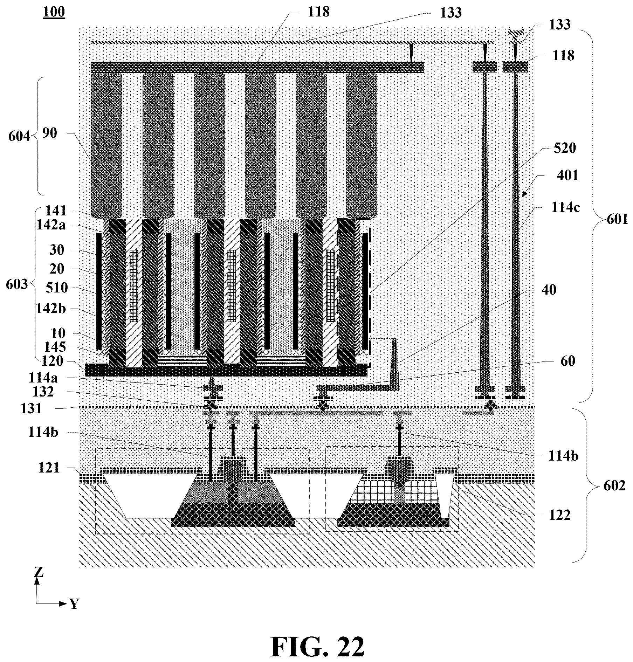

In some examples of the present application, the substrate 1 may comprise a first region R1 as shown in FIGs. 12 and 14. The first region R1 may comprise a core device region for forming a transistor array, memory cells and/or other required components. The transistor array comprises a plurality of transistors, each of which comprises a semiconductor pillar 20. In addition, as shown in FIG. 22, a source 145 and a drain 141 of each transistor are formed at two opposite ends of the semiconductor pillar 20 extending along the third direction Z, and a gate structure 10 of each transistor is disposed on a sidewall of the semiconductor pillar 20.

In some examples, the substrate 1 comprises a material for fabricating the semiconductor device 100, and the material of the substrate 1 may include silicon (e.g., monocrystalline silicon, polysilicon), silicon germanium (SiGe), silicon carbide (SiC), gallium nitride (GaN), indium phosphide (InP), gallium arsenide (GaAs), germanium (Ge), silicon on insulator (SOI), germanium on insulator (GOI) or any suitable combination thereof. The substrate 1 may comprise a wafer formed from cylindrical monocrystalline silicon by steps such as grinding, polishing and dicing, etc.

FIGs. 2-22 are schematic process diagrams of a fabrication method of a semiconductor device 100 provided by examples of the present application. It is to be noted that, in examples of the present application, illustrations are made by taking the gate structures 10 on the sidewalls of adjacent ones of the semiconductor pillars 20 being located on different sides as shown in FIGs. 2-22 as an example.

In some examples, operation S200 forming the first grooves K1 extending along the second direction Y and arranged as being spaced apart along the first direction X in the substrate 1 comprises: etching from a surface of the substrate 1 as shown in FIG. 2 to form the first grooves K1 extending along the second direction Y and arranged as being spaced apart along the first direction X, wherein the first grooves K1 may extend to the substrate 1 along the third direction Z. That is, as shown in FIGs. 1, 2 and 3, the substrate 1 is etched from the surface of the substrate 1 along the third direction Z to form the plurality of first grooves K1 extending along the second direction Y and arranged as being spaced apart along the first direction X.

In some examples, the substrate 1 may be etched using processes such as photolithography (PH) or dry etching (ET), etc., for example, an electron beam lithography process, a plasma etching process or a reactive ion etching process, etc., on which some examples of the present application do not impose limitations.

As shown in FIGs. 2, 3 and 4, during etching of the substrate 1, part of the surface regions of the substrate 1 (i.e., regions where the first grooves K1 are to be formed) may be covered by a mask (not shown in the figure). Then, the surface of the substrate 1 is etched along a thickness direction (i.e., the third direction Z) of the substrate 1. Part of the semiconductor material of the substrate 1 outside the regions covered by the mask is etched off to form grooves with a certain depth, i.e., the above-mentioned first grooves K1.

In some examples, an etching depth to form the first grooves K1 is less than an initial thickness of the substrate 1, that is, the substrate 1 is not etched through during the etching process. As such, part of the semiconductor material of part of the substrate 1 is removed to form the first grooves K1.

In some examples of the present application, the plurality of first grooves K1 with the same depth are synchronously formed by etching the surface of the entire substrate 1, which can simplify the fabrication process and improve efficiency.

Operation S300, depositing a dielectric material 401 in the first grooves K1.

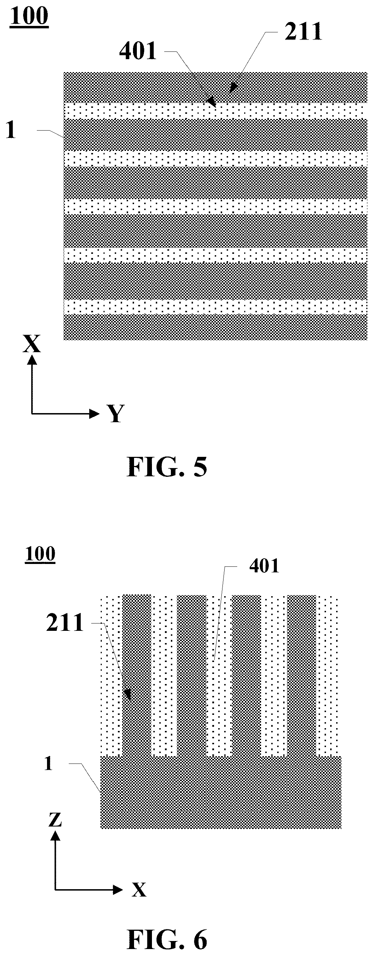

In some examples of the present application, FIG. 5 is a top view of depositing a dielectric material 401 in first grooves K1 provided by some examples of the present application, and FIG. 6 is a cross-sectional view of depositing a dielectric material 401 in first grooves K1 provided by some examples of the present application. After the formation of the first grooves K1 as shown in FIGs. 3 and 4, the dielectric material 401 is deposited in the first grooves K1 using a deposition process, as shown in FIGs. 5 and 6.

In some examples, the dielectric material 401 includes, but is not limited to, any one or any combination of polysilicon, silicon nitride, silicon oxide and aluminum oxide. Here, silicon oxide refers to a silicon-oxygen compound, such as SixOy, and silicon nitride refers to a nitrogen-silicon compound, such as SixNy.

Since the first grooves K1 are formed as shown in FIGs. 3 and 4 and the plurality of first grooves K1 are arranged as being spaced apart along the first direction X, there is a protrusion structure 211 between the first grooves K1 formed in the substrate 1 by removing part of the semiconductor material, and the protrusion structure 211 is for spacing two adjacent ones of the first grooves K1. It is to be noted that, during actual deposition of the dielectric material 401, the dielectric material 401 will cover the surface of the protrusion structure 211, and the dielectric material 401 is filled around each protrusion structure 211 as shown in FIG. 5. In addition, after the deposition is finished, excess dielectric material 401 is removed by grinding using a chemical mechanical polishing (CMP) process.

In some examples of the present application, a deposition method of the dielectric material 401 may include, but is not limited to, chemical vapor deposition (CVD), physical vapor deposition (PVD), plasma-enhanced CVD (PECVD), sputtering, metal-organic chemical vapor deposition (MOCVD) and atomic layer deposition (ALD), etc.

Operation S400, forming second grooves K2 and third grooves K3 extending along the first direction X in the substrate 1, wherein the second grooves K2 and the third grooves K3 are spaced apart in a staggered arrangement along the second direction Y, sizes of the second grooves K2 along the first direction X are smaller than sizes of the third grooves K3 along the first direction X, and orthographic projections of the second grooves K2 are within ranges of orthographic projections of the third grooves K3 along the second direction Y.

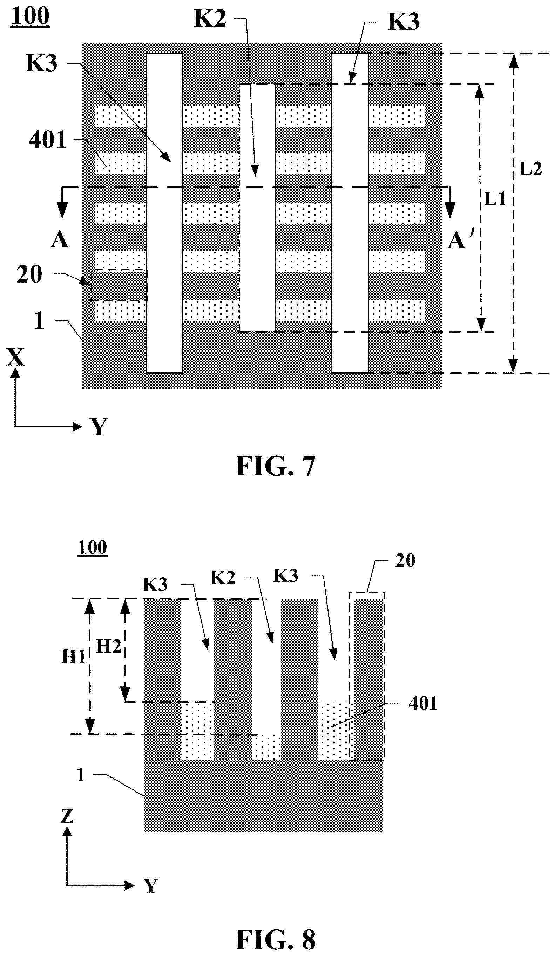

In some examples of the present application, after filling the dielectric material 401 in the first grooves K1, the second grooves K2 and the third grooves K3 extending along the first direction X are formed in the substrate 1. The plurality of second grooves K2 and the plurality of third grooves K3 are in a staggered arrangement along the second direction Y, and the semiconductor pillar 20 is located between the adjacent second groove K2 and third groove K3. That is, as shown in FIGs. 7 and 8, the second grooves K2 and the third grooves K3 are in a staggered arrangement along the second direction Y. The second grooves K2 extending along the first direction X and the third grooves K3 extending along the first direction X are formed synchronously, which can simplify the manufacturing process and improve efficiency. Of course, the second grooves K2 and the third grooves K3 may be formed in steps successively in the examples of the present application.

As shown in FIG. 7, first etching lengths of the second grooves K2 (i.e., extending sizes L1 of the second grooves K2 along the first direction X) are less than second etching lengths of the third grooves K3 (i.e., extending sizes L2 of the second grooves K2 along the first direction X). The etching lengths may be controlled by process parameters of etching, such as etching duration, gas flow rate, proportion, pressure, temperature, etc. For example, in the case of a constant etching rate, the longer the etching duration is, the wider the grooves formed are in the first direction X. In an example of the present application, by adjusting the process parameters of etching, the second etching lengths of the third grooves K3 may be greater than the first etching lengths of the second grooves K2. The etching method may include dry etching, which may be, for example, plasma etching.

In some examples of the present application, the fabrication method of the semiconductor device 100 may further comprise: making sizes of the second grooves K2 along the third direction Z be greater than sizes of the third grooves K3 along the third direction Z, and making the orthographic projections of the second grooves K2 be within the ranges of the orthographic projections of the third grooves K3 along the second direction, wherein the first direction X, the second direction Y and the third direction Z intersect each other.

In some examples, the etching of the substrate 1 may be performed by using, for example, a dry etching process or a wet etching process. If the substrate 1 is etched using the dry etching process, the extending sizes of the second grooves K2 and the second grooves K3 along the third direction Z may be controlled by controlling the time of dry etching. As shown in FIG. 8, first etching depths (extending sizes H1 along the third direction Z) of the second grooves K2 are greater than second etching depths (i.e., extending sizes H2 along the third direction Z) of the third grooves K3.

In some examples, etching depths may be controlled by the process parameters of etching, such as etching duration, gas flow rate, proportion, pressure, temperature, etc. For example, in the case of a constant etching rate, the longer the etching duration is, the deeper the grooves formed are in the third direction Z. In an example of the present application, by adjusting the process parameters of etching, the first etching depths of the second grooves K2 may be greater than the second etching depths of the third grooves K3. An etching method may include dry etching, which may be, for example, plasma etching.

FIG. 7 is a top view of forming second grooves K2 and third grooves K3 by etching provided by some examples of the present application, and FIG. 8 is a cross-sectional view of forming second grooves K2 and third grooves K3 by etching provided by some examples of the present application. As shown in FIGs. 7 and 8, part of the dielectric material filled between the protrusion structures 211 in the substrate 1 is removed to form the second grooves K2 and the third grooves K3. The plurality of second grooves K2 and third grooves K3 arranged as being spaced apart along the second direction Y expose the adjacent protrusion structures, so as to form the semiconductor pillars 20 distributed in an array between the second grooves K2 and the third grooves K3 as shown in FIG. 7 along the second direction Y.

The semiconductor pillars 20 are used to transfer charges or stop the transfer of charges under an external electric field to turn on or tun off the transistors. Moreover, an extending direction of each of the semiconductor pillars 20 is perpendicular to the substrate 1. Here, the extending direction of the semiconductor pillars 20 is a current direction when the transistors are turned on. The semiconductor pillars 20 are distributed in an array along the first direction X and the second direction Y.

In some examples, as shown in FIGs. 7 and 8, the second grooves K2 expose the semiconductor pillars 20 in the same column among the semiconductor pillars 20 distributed in an array, the gate structures 10 of the semiconductor pillars 20 in the same column are connected with each other, and the gate structures 10 connected with each other form a word line of the same column of the semiconductor pillars 20. The word line may provide word line voltages, and each transistor is controlled to be turned on or off through the word line voltages.

Operation S500, forming gate line structures in the second grooves K2.

Operation S600, forming shielding structures 30 in the third grooves K3.

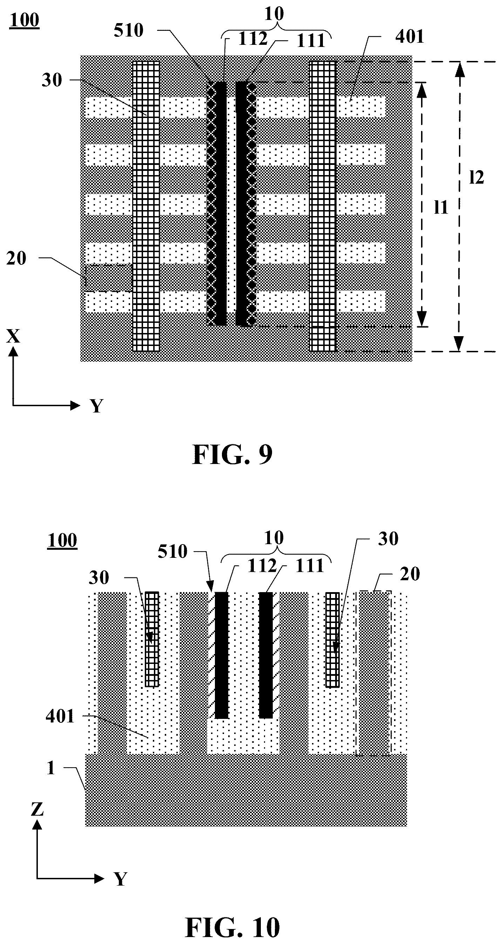

In some examples, as shown in FIGs. 7 and 8, after the formation of the second grooves K2 and the third grooves K3, as shown in FIG. 9, a sacrificial material may be deposited in the second grooves K2, part of the sacrificial material filled in the third grooves K3 may be removed by using a mask, and then a metal material is deposited to form the shielding structures 30. The sacrificial material is deposited in the third grooves K3, part of the sacrificial material filled in the second grooves K2 may be removed by using a mask, then a gate dielectric layer 510 is formed along inner walls of the second grooves K2, and a metal material is deposited on sidewalls of the gate dielectric layer 510 to form the gate structures 10.

In some examples, the gate line structures may be first formed in the second grooves K2 and then the shielding structures 30 are formed in the third grooves K3; or the shielding structures 30 may be first formed in the third grooves K3 and then the gate line structures are formed in the second grooves K2; or the gate line structures and the shielding structures 30 may be synchronously formed in the second grooves K2 and the third grooves K3 respectively.

In some examples, a deposition method of the metal material may include, but is not limited to, chemical vapor deposition (CVD), physical vapor deposition (PVD), plasma-enhanced CVD (PECVD), sputtering, metal-organic chemical vapor deposition (MOCVD) and atomic layer deposition (ALD), etc.

In some examples of the present application, the shielding structures 30 are formed synchronously using a formation process of the gate structures 10 without adding additional process operations, which can shield the adjacent semiconductor pillars 20 from interference of the gate structures 10, thereby improving a coupling effect between the gate structures 10 and the adjacent semiconductor pillars 20.

In some examples, the semiconductor device 100 as shown in FIG. 12 formed by examples of the above operations S100 to S600 comprises:
a first region R1 that comprises a semiconductor pillar array, wherein the semiconductor pillar array comprises a plurality of semiconductor pillars 20 that are arranged in an array along a first direction X and a second direction Y and extend in a third direction Z, and the first direction X, the second direction Y and the third direction Z intersect each other; and
a plurality of gate structures 10 and shielding structures 30 extending along the first direction X, wherein the gate structures 10 and the shielding structures 30 are in a staggered distribution along the second direction Y, and the semiconductor pillars 20 are located between the shielding structures 30 and the gate structures 10 that are adjacent,
wherein sizes of the gate structures 10 along the first direction X are smaller than sizes of the shielding structures 30 along the first direction X, and orthographic projections of the gate structures 10 are within ranges of orthographic projections of the shielding structures 30 along the second direction Y.

In an example, orthographic projections of the shielding structures 30 and orthographic projections of the gate structures 10 in the first direction X overlap, extending sizes of the shielding structures 30 in the first direction X are greater than extending sizes of the gate structures 10 in the first direction X, and orthographic projections in the second direction Y of ends of the gate structures 10 in the first direction X overlap and are within orthographic projections in the second direction Y of ends of the shielding structures 30 in the first direction X. In an example of the present application, by adjusting the process parameters of etching, the second etching lengths (the extending sizes L2 in the first direction X) of the third grooves K3 may be greater than the first etching lengths (the extending sizes L1 in the first direction X) of the second grooves K2 as shown in FIG. 7. As such, as shown in FIGs. 9, 12 and 14, the extending sizes 12 of the shielding structures 30 formed in the third grooves K3 in the first direction X may be greater than the extending sizes 11 of the gate structures 10 formed in the second grooves K2 in the first direction X, and the ends of the gate structures 10 in the first direction X are within ranges of the ends of the shielding structures 30 in the first direction X.

In some examples, the sizes of the gate structures 10 along the third direction Z are greater than the sizes of the shielding structures 30 along the third direction Z, and the orthographic projections of the gate structures 10 are within the ranges of the orthographic projections of the shielding structures 30 along the second direction Y.

In an example, the orthographic projections of the shielding structures 30 and the orthographic projections of the gate structures 10 in the third direction Z overlap, the extending sizes of the shielding structures 30 in the third direction Z are smaller than the extending sizes of the gate structures 10 in the third direction Z, and orthographic projections in the second direction Y of ends of the shielding structures 30 in the third direction Z overlap and are within orthographic projections in the second direction Y of ends of the gate structures 10 in the third direction Z. In an example of the present application, by adjusting the process parameters of etching, the first etching depths (the extending sizes H1 in the third direction Z) of the second grooves K2 may be greater than the second etching depths (the extending sizes H2 in the third direction Z) of the third grooves K3. As such, as shown in FIGs. 10, 11 and 13, the extending sizes h1 of the gate structures 10 formed in the second grooves K2 in the third direction Z may be greater than the extending sizes h2 of the shielding structures 30 formed in the third grooves K3 in the third direction Z, and the ends of the shielding structures 30 in the third direction Z are within ranges of the ends of the gate structures 10 in the third direction Z.

In some examples, first surfaces of the shielding structures 30 away from the substrate 1 are not higher than first surfaces of the gate structures 10 away from the substrate 1, and second surfaces of the shielding structures 30 close to the substrate 1 are not lower than second surfaces of the gate structures 10 close to the substrate 1.

In an example, as shown in FIG. 10, the first surfaces (referred to as top surfaces hereinafter for ease of description) of the shielding structures 30 away from the substrate 1 along the third direction Z are flush with top surfaces of the gate structures 10 along the third direction Z, and the second surfaces (referred to as bottom surfaces hereinafter for ease of description) of the shielding structures 30 close to the substrate 1 along the third direction Z are higher than bottom surfaces of the gate structures 10 along the third direction Z.

For another example, as shown in FIGs. 11, 13 and 15, the top surfaces of the shielding structures 30 along the third direction Z are lower than the top surfaces of the gate structures 10 along the third direction Z, and the bottom surfaces of the shielding structures 30 along the third direction Z are higher than the bottom surfaces of the gate structures 10 along the third direction Z.

In some examples of the present application, the gate structure 10 comprises a first gate 111 and a second gate 112 that are adjacent in the second direction Y. The first gate 111 and the second gate 112 are respectively located on a side of the semiconductor pillars 20 adjacent thereto.

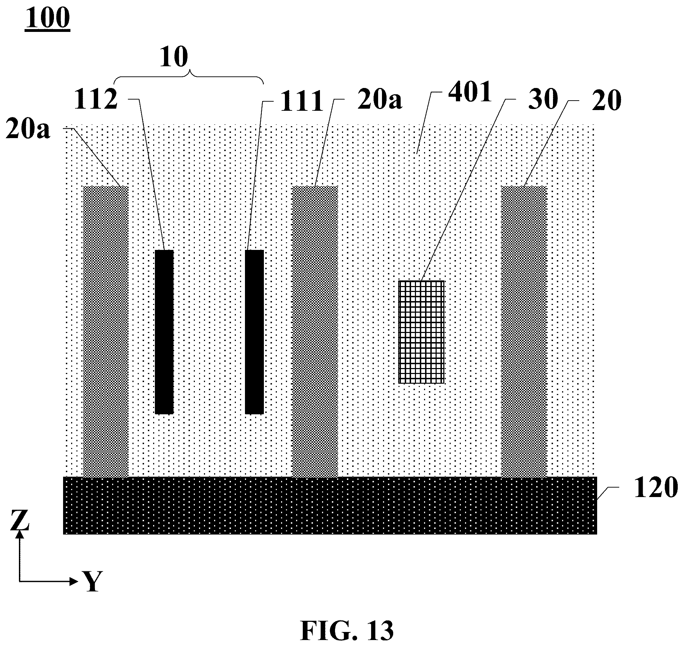

In some examples, as shown in FIG. 13, the gate structure 10 comprises the first gate 111 and the second gate 112 extending along the first direction X. The first gate 111 and the second gate 112 in the same gate structure 10 are adjacent in the second direction Y, and the first gate 111 and the second gate 112 are respectively located on a side of the semiconductor pillars 20 adjacent thereto. For example, as shown in FIG. 13, the semiconductor pillar 20a and the semiconductor pillar 20b are adjacent in the second direction Y. One gate structure 10 is located between the semiconductor pillar 20a and the semiconductor pillar 20B. The first gate 111 in the gate structure 10 is close to a side of the semiconductor pillar 20a along the second direction Y, and the second gate 112 of the gate structure 10 is close to a side of the semiconductor pillar 20b along the second direction Y.

In some examples of the present application, as shown in FIGs. 7, 8, 9 and 10, oxidation processing is performed on the exposed sidewalls of the semiconductor pillars 20 through the second grooves K2, to form the gate dielectric layer 510 on the sidewalls of the semiconductor pillars 20. A process for performing the oxidation processing on the sidewalls of the above-mentioned semiconductor pillars 20 exposed in the second grooves K2 includes, but is not limited to, direct oxidation, alkaline oxidation or acid oxidation. In some examples of the present application, by direct oxidation through heating, silicon on the sidewalls of the semiconductor pillars 20 has chemical reaction with gases containing oxidizing substances at a high temperature, such that a layer of dense silicon dioxide film is generated on silicon surfaces, thereby forming the gate dielectric layer 510 on the sidewalls of the semiconductor pillars 20. The gate dielectric layer 510 includes an insulating material, such as silicon oxide and silicon oxynitride. The gate dielectric layer 510 is located between the semiconductor pillar 20 and the first gate 111 or the second gate 112 of the gate structure 10 formed as shown in FIGs. 9, 10, 11 and 22. The gate dielectric layer 510 is configured to isolate the gate structures 10 from the semiconductor pillars 20 to avoid charge leakage caused by direct contact between the gate structures 10 and the semiconductor pillars 20.

As shown in FIGs. 9, 10 and 11, the specific description of forming the gate structures 10 and the shielding structures 30 in the second grooves K2 and the third grooves K3 respectively may refer to the examples corresponding to S500 to S600 above, which is no longer repeated here.

In some examples, as shown in FIGs. 7, 12, 14 and 19, the extending sizes 12 of the shielding structures 30 along the first direction X are greater than the extending sizes 11 of the gate structures 10 along the first direction X, i.e., 12 > 11. As shown in FIGs. 10, 11, 12, 13, 15 and 22, the extending sizes h1 of the shielding structures 30 along the extending direction of the semiconductor pillars 20 (i.e., the third direction Z) are smaller than the extending sizes h2 of the gate structures 10 along the extending direction of the semiconductor pillars 20 (i.e., the third direction Z), i.e., h1 < h2. The above-mentioned extending sizes along the first direction X and the extending sizes along the third direction Z may be controlled by adjusting the etching lengths and the etching depths of the third grooves K3 and the second grooves K2 as shown in FIGs. 7 and 8, and the process parameters of etching include, but are not limited to, etching duration, etching gas flow rate, proportion, pressure, temperature, etc.

In some examples, the semiconductor device 100 further comprises a second region R2. The second region R2 and the first region R1 are arranged along the first direction X. The second region R2 comprises first conductive portions 210 that each comprise a first leading-out structure 40 extending along the third direction Z and a first connector 60 extending along the first direction X. Two ends of the first leading-out structure 40 along the third direction Z are in contact connection with the first connector 60 and the gate structure 10 respectively, and the first conductive portions 210 are located on a side of the shielding structure 30 along the third direction Z.

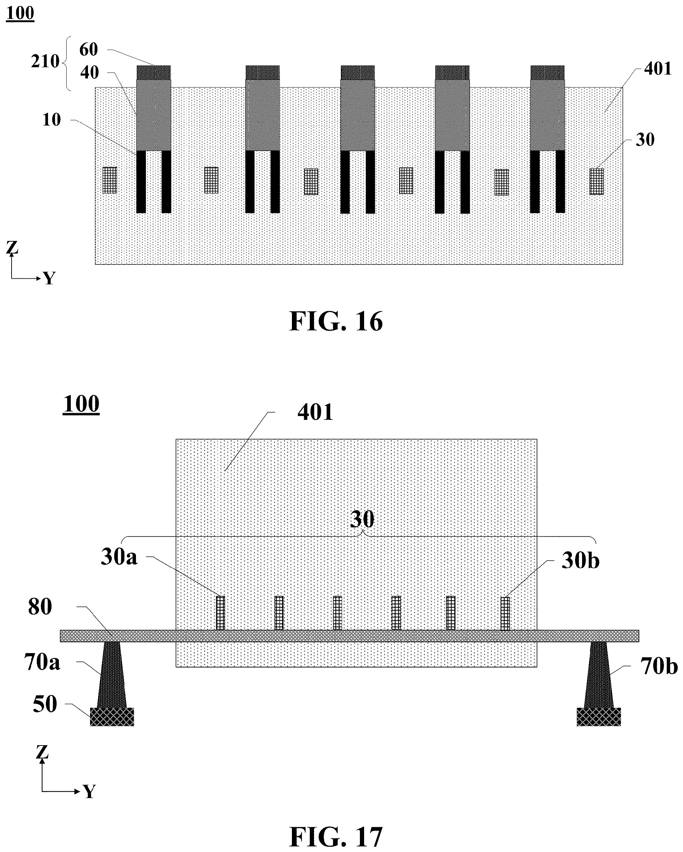

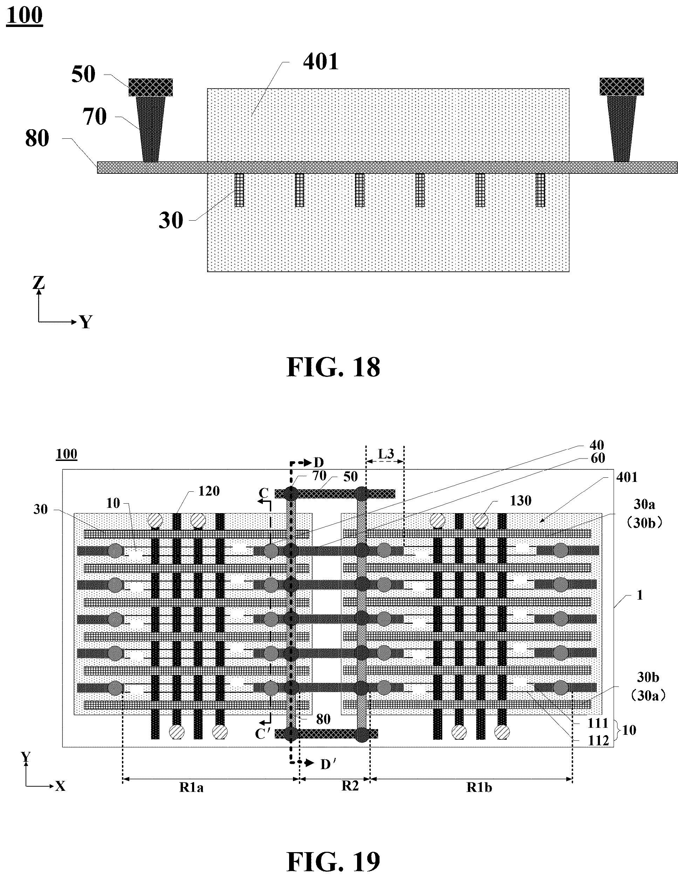

In an example, the second region R2 may comprise a transition region for connecting with the first region R1, but the present application is not limited thereto. As shown in FIGs. 14 and 19, the first region R1 and the second region R2 are arranged in the first direction X. The second region R2 comprises the first conductive portions 210, and the gate structures 10 in the first region R1 can establish connections with the first conductive portions 210 in the second region R2. Referring to FIGs. 15, 16 and 22, the first conductive portions 210 each comprise the first leading-out structure 40 and the first connector 60. As shown in FIGs. 15 and 16, the first connector 60 extends along the first direction X. As shown in FIG. 22, the first leading-out structure 40 extends along the third direction Z. As shown in FIGs. 15 and 16, the two ends of the first leading-out structure 40 along the third direction Z are in contact connection with the first connector 60 and the gate structure 10 respectively. The first conductive portions 210 may be located on any side of the shielding structure 30 along the third direction Z.

In some examples, the first conductive portions 210 may be located on a first side of the shielding structure 30 along the third direction Z. As shown in FIG. 15, the bottom surface of the gate structure 10 along the third direction Z is connected with a top surface of the first leading-out structure 40 along the third direction Z, and a bottom surface of the first leading-out structure 40 along the third direction Z is connected with a top surface of the first connector 60 along the third direction Z, and a bottom surface of the first connector 60 along the third direction Z may be connected with a periphery circuit. In this way, the first conductive portions 210 may be led out from a front surface of the substrate 1.

In some examples, the first conductive portions 210 may be located on a second side of the shielding structure 30 along the third direction Z. As shown in FIG. 16, the top surface of the gate structure 10 along the third direction Z is connected with the bottom surface of the first leading-out structure 40 along the third direction Z, and the top surface of the first leading-out structure 40 along the third direction Z is connected with the bottom surface of the first connector 60 along the third direction Z, and the top surface of the first connector 60 along the third direction Z may be connected with the periphery circuit. In this way, the first conductive portions 210 may be led out from a back surface of the substrate 1.

In some examples, the semiconductor device 100 comprises a plurality of first regions R1 and a plurality of second regions R2, wherein two adjacent ones of the first regions R1 along the first direction X are connected through one of the second regions R2, and the gate structures 10 in two adjacent ones of the first regions R1 are connected through the first conductive portions 210.

In an example, FIGs. 14 and 19 only exemplarily show two first regions R1 and one second region R2 that are connected alternately, wherein the first region R1a is connected with the first region R1b through the second region R2. In other implementations, the semiconductor device 100 may further comprise three first regions R1 and two first regions R1 that are connected alternately. Of course, the semiconductor devices 100 comprising other numbers and arrangements of the first regions R1 and the second regions R2 are all within the protection scope of the present application, which is not limited herein.

For ease of description, the present application takes two first regions R1 and one second region R2 disposed alternately in the first direction X as an example. As shown in FIGs. 14 and 19, the two first regions R1 and the second region R2 are arranged alternately in the first direction X, and the second region R2 is located between two adjacent first regions R1. The second region R2 comprises the first conductive portions 210, and the gate structures 10 in the two adjacent first regions R1 are connected through the first leading-out structures 40 of the first conductive portions 210. Then, the first leading-out structures 40 are connected with the first connectors 60 of the first conductive portions 210, such that the plurality of gate structures 10 in the two adjacent first regions R1 each establish a connection through the first conductive portions 210 in the second region R2.

In some examples, materials of the first connector 60 and the first leading-out structure 40 of the first conductive portion 210 may include a conductive material, including, but not limited to, tungsten (W), cobalt (Co), copper (Cu), aluminum (Al), silicide or any combination thereof.

In some examples, the second region R2 further comprises second conductive portions 220 extending along the second direction Y, and the plurality of shielding structures 30 in the first regions R1 are connected through the second conductive portions 220.

In particular, the present application takes two first regions R1 and one second region R2 disposed alternately in the first direction X as an example. As shown in FIGs. 14 and 19, the two first regions R1 and the second region R2 are arranged alternately in the first direction X, and the second region R2 is located between the two adjacent first regions R1. The second region R2 comprises the second conductive portions 220, and the shielding structures 30 in the two adjacent first regions R1 are connected through the second conductive portions 220, such that the plurality of shielding structures 30 in the two adjacent first regions R1 each establish a connection through the second conductive portions 220 in the second region R2.

As shown in FIGs. 14, and 17 to 21, the second region R2 further comprises the second conductive portions 220, and the plurality of shielding structures 30 in the first regions R1 are connected through the second conductive portions 220, that is, one end of each of the plurality of shielding structures 30 is connected with the corresponding one of the second conductive portions 220. The second conductive portions 220 may be located on any side of the shielding structures 30 along the third direction Z.

In some examples, the first region R1 further comprises:
a bit line 120 located on a side of the semiconductor pillars 20 along the third direction Z and connected with drains of the semiconductor pillars 20, wherein the bit line 120 extends along the second direction Y; and
the second conductive portions 220 are located on a side of the shielding structures 30 relatively close to the bit line 120 along the third direction Z.

In an example, as shown in FIGs. 13, 14, 19 and 22, the first region further comprises the bit line 120, and the semiconductor pillar 20 comprises a source 145 and a drain 141 located on two opposite sides along the third direction Z, wherein the source 145 and the drain 141 of a transistor are respectively located on two opposite sides of the semiconductor pillar 20 along the third direction Z. It may be understood that the source 145 and the drain 141 of the transistor are regarded as a relative concept, and the source 145 and the drain 141 may be any end of the semiconductor pillar 20 along the third direction Z. The bit line 120 extending along the first direction X is located on a side of the semiconductor pillar 20 along the third direction Z. The bit line 120 is connected with the drain 141 of the semiconductor pillar 20. The second conductive portions 220 are located on a side of the shielding structures 30 relatively close to the bit line 120 along the third direction Z.

In some examples, a bit line 120 located on a side of the semiconductor pillars 20 along the third direction Z and connected with the drains of the semiconductor pillars 20, wherein the bit line 120 extends along the second direction Y; and
the second conductive portions 220 are located on a side of the shielding structures 30 relatively away from the bit line 120 along the third direction Z.

As shown in FIGs. 13, 14, 19 and 22, the first region further comprises the bit line 120, and the semiconductor pillar 20 comprises a source 145 and a drain 141 located on two opposite sides along the third direction Z, wherein the source 145 and the drain 141 of a transistor are respectively located on two opposite sides of the semiconductor pillar 20 along the third direction Z. It may be understood that the source 145 and the drain 141 of the transistor are regarded as a relative concept, and the source 145 and the drain 141 may be any end of the semiconductor pillar 20 along the third direction Z. The bit line 120 extending along the first direction X is located on a side of the semiconductor pillar 20 along the third direction Z. The bit line 120 is connected with the drain 141 of the semiconductor pillar 20. The second conductive portions 220 are located on a side of the shielding structures 30 relatively away from the bit line 120 along the third direction Z. Illustrations are made below based on specific devices of the second conductive portions 220.

In some examples, the second conductive portions 220 each comprise a second connector 80 extending along the second direction Y, wherein the second connector 80 is connected with the plurality of shielding structures 30, and there is spacing L3 between a side of the gate structure 10 close to the second connector 80 and the second connector 80 in the first direction X.

In an example, as shown in FIGs. 14, 17, 18 and 19, the second conductive portions 220 each comprise the second connector 80 extending along the second direction Y. The plurality of shielding structures 30 are connected with the second connector 80, there is the spacing L3 between the side of the gate structure 10 close to the second connector 80 and the second connector 80 in the first direction X, and a numerical value of the spacing L3 may be set as needed. As shown in FIGs. 14 and 19, there is the spacing L3 in the first direction X between the side of the gate structure 10 close to the second connector 80 (i.e., a side close to the first leading-out structure 40 of the first conductive portion 210 in the figures) and the second connector 80 extending along the second direction Y, which can facilitate leading-out of the gate structure 10.

In some examples, the second conductive portions 220 may each comprise one second connector 80 on a first side of the shielding structure 30 along the third direction Z. In addition, the second conductive portions 220 may each further comprise one second connector 80 on a second side of the shielding structure 30 along the third direction Z. The second conductive portions 220 may each further comprise one second connector 80 on the first side of the shielding structure 30 along the third direction Z, and another second connector 80 on the second side of the shielding structure 30 along the third direction Z. A material of the second connector 80 may include a conductive material, including, but not limited to, tungsten (W), cobalt (Co), copper (Cu), aluminum (Al), silicide or any combination thereof.

In some examples, the second conductive portions 220 each further comprise: at least one second leading-out structure 70 extending along the third direction Z, wherein the second leading-out structure 70 is connected with the second connector 80, and is located at an end of the second connector 80 away from the plurality of shielding structures 30 along the second direction Y.

In an example, as shown in FIGs. 14, 17, 18 and 19, the second conductive portions 220 each further comprise at least one second leading-out structure 70 extending along the third direction Z. As shown in FIGs. 17 and 18, the second leading-out structure 70 is connected with the second connector 80, and is located at the end of the second connector 80 away from the plurality of shielding structures 30 in the second direction Y. That is to say, there is certain spacing between the end of the second connector 80 along the second direction Y and the outermost one of the shielding structures 30 arranged as being spaced apart in the second direction Y. For example, as shown in FIG. 17, the second leading-out structure 70 is located at an end of the second connector 80 away from the outermost one of the plurality of shielding structures 30 in the second direction Y, or the second leading-out structure 70 is located at an end of the second connector 80 away from the outermost one of the plurality of shielding structures 30 in the second direction Y. In this way, one second leading-out structure 70 is away from the outermost shielding structure 30a (or 30b) along the second direction Y, such that there is spacing between the second leading-out structure 70 and the outermost shielding structure 30a (or 30b), which is favorable to reduce the crosstalk/coupling effect between the shielding structure 30 comprising the conductive material and the second leading-out structure 70 and improves the device performance.

A material of the second leading-out structure 70 includes a conductive material, including, but not limited to, tungsten (W), cobalt (Co), copper (Cu), aluminum (Al), silicide or any combination thereof. The second leading-out structure 70 is connected with the first connector 80, and the second leading-out structure 70 is located at an end away from the plurality of shielding structures 30 arranged in juxtaposition as being spaced apart along the second direction Y. In an example, as shown in FIGs. 14, 17, 18 and 19, one second leading-out structure 70a is connected with a first end of the second connector 80 away from the outermost shielding structure 30a in the second direction Y, another second leading-out structure 70b is connected with a second end of the second connector 80 away from the outermost shielding structure 30b in the second direction Y, and the first end of the second connector 80 and the second end of the second connector 80 may be respective ends of the second connector 80 along the second direction Y.

In some examples, along the third direction Z, the shielding structure 30 and the second leading-out structure 70 are located on two opposite sides of the second connector 80.

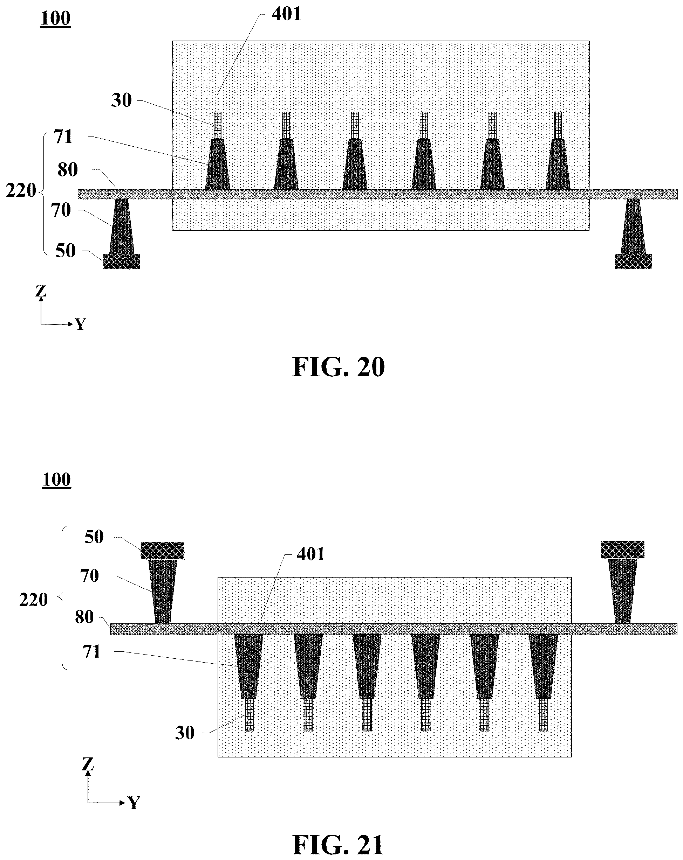

In an example, as shown in FIGs. 17 and 20, along the third direction Z, the shielding structure 30 and the second leading-out structure 70 are located on the two opposite sides of the second connector 80. The shielding structure 30 and the second leading-out structure 70 of the second conductive portion 220 are disposed on the two opposite sides of the second connector 80 in the third direction Z respectively, which can reduce occupied area of the device, thereby reducing the size of the semiconductor device 100.

In some examples, as shown in FIG. 17, the second leading-out structure 70 may be located on a side of the shielding structure 30 away from the bit line 120 along the third direction Z. As such, the second conductive portion 220 can be led out from the front surface of the substrate 1.

In some examples, as shown in FIG. 18, the second leading-out structure 70 may be also located on the side of the shielding structure 30 away from the bit line 120 along the third direction Z. As such, the second conductive portion 220 can be led out from the back surface of the substrate 1.

In some examples, the shielding structure 30 is in contact connection with the second connector 80. In an example, as shown in FIGs. 17 and 18, each of the shielding structures 30 is in direct contact connection with the second connector 80.

In some examples, the second conductive portions 220 each further comprise: at least one third leading-out structure 71 extending along the third direction Z, wherein the shielding structures 30 are each connected with the second connector 80 through one third leading-out structure 71, and the third leading-out structure 71 and the second leading-out structure 70 are located on different sides of the second connector 80 along the third direction Z.

In an example, as shown in FIGs. 14, 19, 20 and 21, the second conductive portions 220 each further comprise at least one third leading-out structure 71 extending along the third direction Z, wherein the number of the third leading-out structures 71 may be the same as or different from the number of the shielding structures 30. The plurality of shielding structures 30 arranged in juxtaposition as being spaced apart along the second direction Y are each connected with the second connector 80 extending along the second direction Y through one third leading-out structures 71, that is to say, the third leading-out structure 71 is located between the second connector 80 and the shielding structure 30 in the third direction Z, i.e., two ends of the third leading-out structure 71 along the third direction Z are in contact connection with the second connector 80 and the shielding structure 30 respectively, such that each shielding structure 30 may be also indirectly connected with the second connector 80. It is to be noted that, the third leading-out structure 71 and the second leading-out structure 70 are located on different sides of the second connector 80 along the third direction Z, that is to say, along the third direction Z, the second connector 80 is located between the third leading-out structure 71 and the second leading-out structure 70.

A material of the third leading-out structure 71 includes a conductive material, including, but not limited to, tungsten (W), cobalt (Co), copper (Cu), aluminum (Al), silicide or any combination thereof.

In some examples, the second conductive portions 220 each further comprise: a third connector 50 extending along the first direction X, wherein the third connector 50 is connected with the second connector 80 through the second leading-out structure 70.

In an example, as shown in FIGs. 14, 17, 18, 19, 20 and 21, the second conductive portions 220 each further comprise the third connector 50 extending along the first direction X. The third connector 50 is connected with the second connector 80 through the second leading-out structure 70, that is to say, the second leading-out structure 70 is located on different sides of the second connector 80 and the third connector 50 in the third direction Z, i.e., the second leading-out structure 70 is located between the third connector 50 and the second connector 80 along the third direction Z.

A material of the third connector 50 includes a conductive material, including, but not limited to, tungsten (W), cobalt (Co), copper (Cu), aluminum (Al), silicide or any combination thereof.

In some examples, the materials of the second leading-out structure 70 and the third leading-out structure 71 may be the same, and shapes of the second leading-out structure 70 and the third leading-out structure 71 may be a regular trapezoid, or may be a rectangle or any other shapes. In an example, a size of a top surface of the third leading-out structure 71 along the first direction X is smaller than a size of a bottom surface of the third leading-out structure 71 along the first direction X, and a size of a top surface of the second leading-out structure 70 is smaller than a size of a bottom surface of the second leading-out structure 70 along the first direction X.

In some examples, along the third direction Z, the shielding structure 30 is located on a side of the second connector 80 relatively away from the bit line 120.

In an example, as shown in FIGs. 17, 18, 20 and 21, along the third direction Z, the third connector 50, the second leading-out structure 70, the second connector 80 and the third leading-out structure 71, together as one second conductive portion 220, are connected with the shielding structure 30. If the shielding structure 30 is located on the side of the second connector 80 relatively away from the bit line 120 along the third direction Z, it is equivalent to that the second conductive portion 220 is located on a side of the shielding structure 30 relatively close to the bit line 120 along the third direction Z, that is to say, the shielding structure 30 is located above the second connector 80 along the third direction Z, which also indicates that the shielding structure 30 is relatively away from the bit line 120 along the third direction Z, and the second connector 80 is closer to the bit line 120 along the third direction Z compared with the shielding structure 30.

In some examples, along the third direction Z, the shielding structure 30 is located on the side of the second connector 80 relatively close to the bit line 120.

In an example, as described above, along the third direction Z, the third connector 50, the second leading-out structure 70, the second connector 80 and the third leading-out structure 71, together as one second conductive portion 220, are connected with the shielding structure 30. Therefore, if the shielding structure 30 is located on the side of the second connector 80 relatively close to the bit line 120 along the third direction Z, it is equivalent to that the second conductive portion 220 is located on the side of the shielding structure 30 relatively away from the bit line 120 along the third direction Z, that is to say, the shielding structure 30 is located below the second connector 80 along the third direction Z, which also indicates that the shielding structure 30 is relatively close to the bit line 120 along the third direction Z, and the second connector 80 is farther away from the bit line 120 along the third direction Z compared with the shielding structure 30.

In a practical application, the first conductive portion 210 and the second conductive portion 220 may be disposed on the same side or different sides of the shielding structure 30 along the third direction Z according to different requirements.

The gate structure 10 is led out through the first conductive portion 210, and the shielding structure 30 is led out through the second conductive portion 220. As shown in FIG. 22, the bit line 120 is connected with the drains of the semiconductor pillars 20, and as shown in FIGs. 12, 14 and 19, leading-out pads 130 of the bit lines 120 are disposed in a staggered arrangement along the second direction Y. In the case where the spacing between the gate structure 10 and the shielding structure 30 is small, the second conductive portion 220 leading out the shielding structure 30 and the first conductive portion 210 leading out the gate structure 10 need to be disposed in a staggered arrangement (disposed on different sides along the third direction), which can prevent the gate structure 10 and the shielding structure 30 from a short circuit, and can reduce the device size and increase the space utilization ratio at the same time.

Of course, in other examples, in the case where the spacing between the gate structure 10 and the shielding structure 30 permits, the second conductive portion 220 leading out the shielding structure 30 and the first conductive portion 210 leading out the gate structure 10 may be disposed on the same side along the third direction Z, for the ease of practical control.

The shielding structure 30, the gate structure 10, the semiconductor pillar 20, the first conductive portion 210 and the second conductive portion 220 may be integrated in a first semiconductor structure 601 as shown in FIG. 22.

In some examples, the first region further comprises:
a capacitor structure that is located on a side of the semiconductor pillar 20 relatively away from the bit line 120 along the third direction Z and extends along the third direction Z,
wherein the capacitor structure comprises a first end connected with the source of the semiconductor pillar 20, and a second end connected with a common end.

The bit line 120 is connected with the drain of the semiconductor pillar 20, one electrode of the capacitor structure 90 is connected with the source of the semiconductor pillar 20, and another electrode of the capacitor structure 90 is connected with the common end (not shown in the figure). In an example, the capacitor structure 90 is used to store data written to the semiconductor device 100. In some examples, the common end may comprise a low voltage end and a ground end, wherein a low voltage may include -0.5V, -1V, etc.

In some examples, the shielding structure 30 is connected with the common end. During a practical application, the shielding structure 30 may be set as being powered separately instead of being connected with the common end according to requirements. In some examples of the present application, the shielding structure 30 may shield the adjacent semiconductor pillar 20 from interference of a word line by applying the low voltage to the shielding structure 30 or grounding the shielding structure 30.

In an example, the semiconductor pillar 20 comprises the source 145 and the drain 141 located on two opposite sides along the third direction Z, wherein the source 145 and the drain 141 of the transistor are located on two opposite sides of the semiconductor pillar 20 along the third direction Z. It may be understood that the source 145 and the drain 141 of the transistor are regarded as a relative concept, and the source 145 and the drain 141 may be any surface of the semiconductor pillar 20 along the third direction Z. The capacitor structure 90 extending along the third direction Z is located on the first side of the semiconductor pillar 20 along the third direction Z, and the bit line 120 extending along the first direction X is located on the second side of the semiconductor pillar 20 along the third direction Z. The bit line 120 is connected with the drain 141 of the semiconductor pillar 20, and the capacitor structure 90 comprises the first end connected with the source of the semiconductor pillar 20, and the second end connected with the common end.

In addition, a capacitor array 604 consisting of the above-mentioned capacitor structures 90, the transistor array (comprising the shielding structure 30, the gate structure 10, the semiconductor pillar 20, the first conductive portion 210 and the second conductive portion 220 in the above examples) and other device structures may be integrated together in the substrate 1 of the above-mentioned first semiconductor structure 601. In some applications of the present application, referring to FIG. 22, the above-mentioned capacitor structure 90 and the transistor array are integrated in the same semiconductor substrate 1, i.e., the substrate 1 of the first semiconductor structure 601 as shown in FIG. 22, and a driving circuit of the memory device may be integrated in another semiconductor substrate 1, i.e., the substrate 1 of a second semiconductor structure 602 as shown in FIG. 22. As such, there may be some non-device blank regions in the substrate 1 integrated with the memory device. These blank regions may be used to form the above-mentioned capacitor array 604, and there is no need to add additional regions to form capacitors, thereby further increasing the integration level of the semiconductor device 100.

Referring to FIG. 22, in the first semiconductor structure 601, the capacitor array 604 and the transistor array are disposed in a stack in the Z direction. One electrode of the capacitor structure 90 in the capacitor array 604 is coupled with the drain 141 of the transistor in the transistor array. One capacitor structure 90 and one transistor (comprising the semiconductor pillar 20, the gate structure 10 and the drain 141 and the source 145 on two opposite sides of the semiconductor pillar 20 along the third direction Z) constitute one DRAM memory cell. Selection and unselection of the connected capacitor structure 90 may be achieved by turning on and off the transistor, which may further achieve read, write or erase operations of the selected memory cells. The examples of the present application do not limit the number of the capacitor structures 90 and the transistors, and the capacitor array 604 may be coupled with the transistor array to constitute a DRAM memory array.

It may be understood that, the source 145 and the drain 141 of the transistor are regarded as a relative concept, and are related to the actual circuit connection of the transistor, but are unrelated to physical positions of the source 145 and the drain 141 in the transistor. In some examples, when the transistor is connected into a circuit, an input end of the transistor connected into the circuit may serve as the source 145, an output end serves as the drain 141, and carriers flow from the source 145 into the drain 141. In order to better explain the coupling relationship between the capacitor structure 90 and the transistor in the examples of the present application, an end of the transistor coupled with the capacitor structure 90 serves as the drain 141, and the source 145 of the transistor may be coupled with the bit line 120 that applies an operation voltage.

In some examples, as shown in FIG. 22, the first semiconductor structure 601 further comprises a first conductive plug 114a that is coupled with the bit line 120. An insulating first filling layer 142a is disposed between adjacent ones of the transistors, and is configured to support the transistors and form electrical isolation.

In some examples, as shown in FIG. 22, an insulating second filling layer 142b is disposed between the gate structure 10 and the gate dielectric layer.

In some examples, composition materials of the first filling layer 142a and the second filling layer may include insulating materials such as silicon oxide, silicon nitride, silicon oxynitride, aluminum oxide, polysiloxane or polysilazane, etc.

In some examples, as shown in FIG. 22, the second semiconductor structure 602 comprises various devices including a CMOS structure. In the Z direction, the first semiconductor structure 601 and the second semiconductor structure 602 are stacked by bonding technology and achieve electrical signal interconnection, wherein the bonding may include hybrid bonding.

Referring to FIG. 22, before the bonding is finished, to-be-bonded planes of the first semiconductor structure 601 and the second semiconductor structure 602 have bonding contacts 132 respectively. The bonding contacts 132 lead out electrical signals of the semiconductor structures to the to-be-bonded planes, and may comprise conductive structures, such as pads, conductive lines, conductive plugs, etc. The pads as shown in FIG. 22 are only examples. The to-be-bonded planes of the first semiconductor structure 601 and the second semiconductor structure 602 are bonded, and an interface where the to-be-bonded planes of the two semiconductor structures contact is a bonding interface 131. The bonding contacts 132 of the first semiconductor structure 601 and the second semiconductor structure 602 are in contact at the bonding interface 131, to achieve electrical signal interconnection between the first semiconductor structure 601 and the second semiconductor structure 602.

A composition material of the bonding contacts 132 may include a conductive material, such as tungsten, gold, silver, platinum, copper, aluminum, titanium or nickel, etc. A composition material of the bonding interface 131 may include silicon oxide, silicon nitride or metal silicide. In the examples of the present disclosure, the bonding interface 131 comprises metal silicide, which can increase adhesion of the bonding contacts 132, reduce stress of the bonding interface 131, reduce bending deformation of the bonding interface 131 and increase fabrication yield.

A first conductive plug 114a may be disposed to lead out an electrical signal of the transistor, and is coupled with the pad on a to-be-bonded surface of the first semiconductor structure 601. A second conductive plug 114b is disposed to lead out electrical signals of the first CMOS structure 121 and the second CMOS structure 122 in the second semiconductor structure 602 individually, and is coupled with the pad on a to-be-bonded surface of the second semiconductor structure 602. In the z direction, the pads of the first semiconductor structure 601 and the pads of the second semiconductor structure 602 serve as the bonding contacts 132, to achieve interconnection of the electrical signals of the two semiconductor structures after the bonding is finished.

In some examples, referring to FIG. 22, the first semiconductor structure 601 further comprises:
an interconnection layer 118 on an end of the capacitor structure 90 away from the transistor along the third direction Z, wherein the interconnection layer 118 is coupled with the capacitor structure 90. A composition material of the interconnection layer 118 may include a conductive material, such as tungsten, gold, silver, platinum, copper, aluminum, titanium or nickel, etc. An electrical signal of the interconnection layer 118 may be led out to the bonding interface 131 through a third conductive plug 114c to achieve electrical signal interconnection with the second semiconductor structure 602.

In some examples, referring to FIG. 22, an interconnection structure 133 is further disposed on a side of the first semiconductor structure 601 away from the bonding interface 131, and can be coupled with the interconnection layer 118 for supplying power to the interconnection layer 118. In some other examples, the interconnection structure 133 may be also coupled with other interconnection layers to supply power.

Some examples of the present application provide a semiconductor device 100 and a manufacturing method thereof. The source 145 and the drain 141 of the transistor array formed by the manufacturing method are respectively located at two ends of the semiconductor pillar 20 in the extending direction that is perpendicular to the substrate 1, and the gate structure 10 is located on a sidewall of the semiconductor pillar 20. As such, the area of the transistor array is significantly reduced, and the storage density of the device is increased. Further, the shielding structure 30 is also formed between adjacent semiconductor pillars 20, and can shield the adjacent semiconductor pillars 20 from interference of the word line.

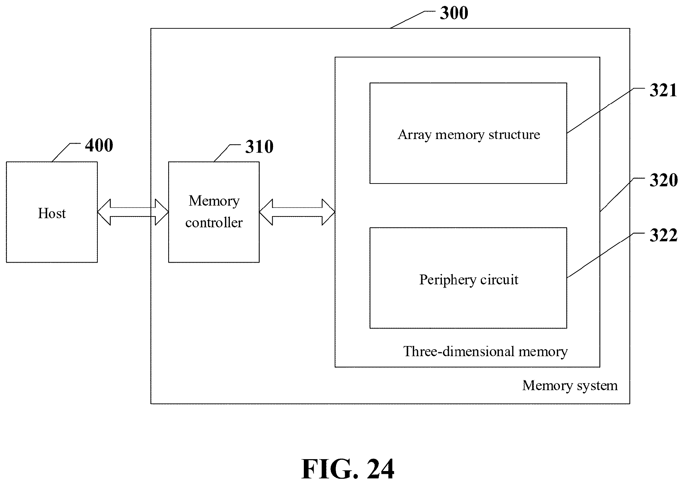

Based on the above-mentioned semiconductor device 100 and the fabrication method thereof, referring to FIG. 24, examples of the present disclosure further provide a memory system 300 which comprises a memory controller 310 and a three-dimensional memory 320, wherein the memory controller 310 is coupled to the three-dimensional memory 320 and configured to control the three-dimensional memory 320 to store data, and the three-dimensional memory 320 comprises the semiconductor device 100 of any one of the above examples.

In an example, as shown in FIG. 24, the memory system 300 comprises the memory controller 310 and one or more three-dimensional memories 320, wherein the three-dimensional memories 320 (3D NAND Flash) comprise a array memory structure 321 and a periphery circuit 322, and wherein the array memory structure 321 comprises the semiconductor device 100 of any one of the above examples. The memory system 300 may communicate with a host 400 through the memory controller 310, wherein the memory controller 310 may be connected to one or more three-dimensional memories 320 via channels in the one or more three-dimensional memories 320. Each three-dimensional memory 320 may be managed by the memory controller 310 via the channel in the three-dimensional memory 320.

In an example, the array memory structure 321 is configured to store information, and the periphery circuit 322 may be located above or below the array memory structure 321, and may be also located around the array memory structure 321. The periphery circuit 322 is configured to control the corresponding array memory structure 321. In addition, the semiconductor device 100 may be further applied in other microelectronic devices, such as a NOR Flash, etc., which is not limited by examples. In addition, the semiconductor device 100 of the examples of the present disclosure may be a three-dimensional memory 320, and may be a part of a periphery memory, which is not limited particularly.

A semiconductor device 100 and a fabrication method thereof and a memory system 300 provided by the examples of the present application are introduced above in detail. The principle and implementations of the present application are set forth herein by applying specific individual examples. The descriptions of the above examples are only to help understand the methods and core ideas of the present application. Meanwhile, those skilled in the art may make changes over the specific implementation and application scope according to the ideas of the present application. To sum up, the contents of this specification should not be interpreted as limitations to the present application.

## Claims

1. A semiconductor device, comprising:
a first region that comprises a semiconductor pillar array, wherein the semiconductor pillar array comprises a plurality of semiconductor pillars that are arranged in an array along a first direction and a second direction and extend in a third direction, and the first direction, the second direction and the third direction intersect each other; and
a plurality of gate structures and shielding structures extending along the first direction, wherein the gate structures and the shielding structures are in a staggered distribution along the second direction, and the semiconductor pillars are located between the shielding structures and the gate structures that are adjacent,
wherein sizes of the gate structures along the first direction are smaller than sizes of the shielding structures along the first direction, and orthographic projections of the gate structures are within ranges of orthographic projections of the shielding structures along the second direction.

2. The semiconductor device of claim 1, wherein sizes of the gate structures along the third direction are greater than sizes of the shielding structures along the third direction, and the orthographic projections of the gate structures are within the ranges of the orthographic projections of the shielding structures along the second direction.

3. The semiconductor device of claim 1, further comprising a second region, wherein the second region and the first region are arranged along the first direction;
the second region comprises first conductive portions that each comprise a first leading-out structure extending along the third direction and a first connector extending along the first direction;
two ends of the first leading-out structure along the third direction are in contact connection with the first connector and the gate structures respectively; and
the first conductive portions are located on a side of the shielding structures along the third direction.

4. The semiconductor device of claim 3, comprising a plurality of first regions and a plurality of second regions, wherein two adjacent ones of the first regions along the first direction are connected through one of the second regions, and the gate structures in two adjacent ones of the first regions are connected through the first conductive portions.

5. The semiconductor device of claim 4, wherein each of the second regions further comprises second conductive portions, and the plurality of shielding structures in the first regions are connected through the second conductive portions.

6. The semiconductor device of claim 5, wherein each of the first regions further comprises:
a bit line located on a side of the semiconductor pillars along the third direction and connected with drains of the semiconductor pillars, wherein the bit line extends along the second direction; and
the second conductive portions are located on a side of the shielding structures relatively close to the bit line along the third direction.

7. The semiconductor device of claim 5, wherein each of the first regions further comprises:
a bit line located on a side of the semiconductor pillars along the third direction and connected with drains of the semiconductor pillars, wherein the bit line extends along the second direction; and
the second conductive portions are located on a side of the shielding structures relatively away from the bit line along the third direction.

8. The semiconductor device of claim 6 or 7, wherein each of the second conductive portions comprises a second connector extending along the second direction, wherein the second connector is connected with the plurality of shielding structures, and there is spacing between a side of the gate structures close to the second connector and the second connector in the first direction.

9. The semiconductor device of claim 8, wherein each of the second conductive portions further comprises: at least one second leading-out structure extending along the third direction, wherein the second leading-out structure is connected with the second connector, and the second leading-out structure is located at an end of the second connector away from the plurality of shielding structures in the second direction.

10. The semiconductor device of claim 9, wherein the shielding structures and the second leading-out structure are located on two opposite sides of the second connector along the third direction.

11. The semiconductor device of claim 10, wherein the shielding structures are in contact connection with the second connector.

12. The semiconductor device of claim 10, wherein each of the second conductive portions further comprises: at least one third leading-out structure extending along the third direction, wherein each of the shielding structures is respectively connected with the second connector through the at least one third leading-out structure, and the third leading-out structure and the second leading-out structure are located on different sides of the second connector along the third direction.

13. The semiconductor device of claim 10, wherein each of the second conductive portions further comprises: a third connector extending along the first direction, wherein the third connector is connected with the second connector through the second leading-out structure.

14. The semiconductor device of claim 11, wherein the shielding structures are located on a side of the second connector relatively away from the bit line along the third direction.

15. The semiconductor device of claim 11, wherein the shielding structures are located on a side of the second connector relatively close to the bit line along the third direction.

16. The semiconductor device of claim 6 or 7, wherein each of the first regions further comprises:
a capacitor structure that is located on a side of the semiconductor pillar relatively away from the bit line along the third direction and extends along the third direction,
wherein the capacitor structure comprises a first end connected with source of the semiconductor pillar, and a second end connected with a common end.

17. The semiconductor device of claim 1, wherein each of the gate structures comprises a first gate and a second gate that are adjacent in the second direction, wherein the first gate and the second gate are respectively located on a side of the semiconductor pillars adjacent thereto.

18. A fabrication method of a semiconductor device, comprising:
providing a substrate;
forming first grooves that extend along a second direction and are arranged as being spaced apart along a first direction in the substrate, wherein the first direction intersects the second direction;
depositing a dielectric material in the first grooves;
forming second grooves and third grooves extending along the first direction in the substrate, wherein the second grooves and the third grooves are spaced apart in a staggered arrangement along the second direction, sizes of the second grooves along the first direction are smaller than sizes of the third grooves along the first direction, and orthographic projections of the second grooves are within ranges of orthographic projections of the third grooves along the second direction;
forming gate line structures in the second grooves; and
forming shielding structures in the third grooves.

19. The fabrication method of the semiconductor device of claim 18, further comprising: making sizes of the second grooves along the third direction be greater than sizes of the third grooves along the third direction, and making the orthographic projections of the second grooves within the ranges of the orthographic projections of the third grooves along the second direction, wherein the first direction, the second direction and the third direction intersect each other.

20. A memory system, comprising: a memory controller and a three-dimensional memory, wherein the memory controller is coupled to the three-dimensional memory and configured to control the three-dimensional memory to store data, and the three-dimensional memory comprises one or more semiconductor devices of any one of claims 1 to 17.
